Europäisches Patentamt

**European Patent Office**

**Office européen des brevets**

(11) Numéro de publication: **0 285 955 B1**

# FASCICULE DE BREVET EUROPEEN

(45) Date de publication de fascicule du brevet: **14.10.92**  (51) Int. Cl.⁵: **G07B 17/02**, G11C 29/00, G01R 31/00

(21) Numéro de dépôt: **88104983.7**

(22) Date de dépôt: **28.03.88**

(54) **Dispositif de couplage de memoires non volatiles dans une machine electronique et machine à affranchir en faisant application.**

(30) Priorité: **31.03.87 FR 8704480**

(43) Date de publication de la demande:
**12.10.88 Bulletin 88/41**

(45) Mention de la délivrance du brevet:
**14.10.92 Bulletin 92/42**

(84) Etats contractants désignés:
**DE FR GB**

(56) Documents cités:
**EP-A- 0 042 749          EP-A- 0 051 332
EP-A- 0 085 385          WO-A-83/02836
DE-A- 3 437 980          FR-A- 2 032 244
GB-A- 2 173 738**

(73) Titulaire: **ALCATEL SATMAM
113 rue Jean-Marin Naudin
F-92220 Bagneux(FR)**

(72) Inventeur: **Vermesse, Bernard
2 avenue de Général de Gaulle
F-94240 L'Haye Les Roses(FR)**

(74) Mandataire: **Weinmiller, Jürgen et al
Lennéstrasse 9 Postfach 24
W-8133 Feldafing(DE)**

Rank Xerox (UK) Business Services

# Description

La présente invention porte sur un mode de couplage de mémoires non volatiles dans une machine électronique, en particulier une machine à affranchir entièrement ou partiellement électronique. (Cf. p. ex. EP-A-0 042 749, GB-A-2 173 738.)

De manière connue, dans les machines à affranchir actuelles, l'équipement électronique qu'elles comportent est organisé autour d'un microprocesseur piloté par un programme. Le microprocesseur gère en particulier une ou des mémoires non volatiles affectées à l'enregistrement de la valeur globale des affranchissements réalisés et, en outre, tout au moins pour les machines à affranchir fonctionnant en pré-paiement, la valeur des crédits successifs chargés dans la machine et celle du crédit restant disponible dans la machine. La mémoire non volatile qui enregistre ces comptes est dite mémoire du compteur de la machine ou mémoire de l'état de la machine.

Etant donné la puissance financière que représente chaque machine à affranchir et à fortiori le parc des machines à affranchir en service, il importe de prévoir dans les machines suffisamment de redondances et de contrôles pour détecter toutes les anomalies de fonctionnement.

Un moyen simple et bien connu répondant à ces buts consiste à doubler les mémoires non volatiles pour enregistrer deux fois, mais de manière séparée, l'état du compteur de la machine. Un décalage entre les contenus des deux mémoires, lorsqu'il est détecté, est utilisé pour déclencher une mise en défaut de la machine. La machine se bloque et rend impossible la réalisation de nouveaux affranchissements.

En cas de défaut provoqué par une panne ou défaillance de composants de l'équipement électronique ou consécutif à une tentative de fraude, il est nécessaire de retrouver l'état du compteur avant l'apparition du défaut. Dans ce but, l'état du compteur est enregistré dans chaque mémoire avec un grand nombre de redondances. En particulier on enregistre dans chaque mémoire non volatile le compteur dit ascendant cumulant les affranchissements réalisés, le compteur dit descendant indiquant le solde de crédit restant disponible et le compteur dit totalisateur cumulant les crédits successifs chargés pour permettre des contrôles arithmétiques entre ces trois compteurs. Souvent, on associe à ces trois compteurs un code de détection d'erreur lié à l'état de chacun de ces compteurs et enregistré avec lui dans chaque mémoire. De telles redondances permettent de mettre en évidence la mémoire éventuellement en défaut. Ces mêmes redondances peuvent aussi conduire, dans un nombre de cas non négligeable, à conclure à l'absence de défaut de la machine et à l'absence de tentative de fraude mais à un simple désalignement des mémoires qu'il suffit alors de rectifier. Le fonctionnement de la machine a pu être altéré par des perturbations fugitives d'origines diverses possibles, telles que électromagnétique, électrostatique ou autre.

Pour retrouver l'état du compteur avant l'apparition du défaut et éventuellement pouvoir diagnostiquer à un simple désalignement des mémoires, une procédure de test est prévue. Elle est effectuée en présence de l'usager et d'un représentant du service postal. La machine à affranchir qui était plombée est alors déplombée pour accéder aux mémoires non volatiles.

Lors de cette procédure de test, on utilise un dispositif dit outil de test pour lire les contenus des mémoires, pour les comparer et faire apparaître les différences et pour vérifier les redondances et mettre en évidence la mémoire éventuellement en défaut. On prévoit, en général, d'équiper l'outil de test d'un connecteur dit de test qui lui est raccordé par l'intermédiaire d'un cordon, et la machine d'un connecteur interne complémentaire du connecteur de test, qui est raccordé en dérivation sur les liaisons entre les bornes d'accès des mémoires et celles de l'équipement électronique et en particulier du microprocesseur.

L'outil de test peut ainsi accéder aux mémoires en venant brancher le connecteur de test sur celui complémentaire prévu à cet effet dans la machine et accessible lorsque la machine est déplombée.

Cet accès aux mémoires non volatiles est en tant que tel de principe simple. Il a cependant nécessité d'inclure dans les liaisons entre les mémoires et l'équipement électronique des résistances d'isolement. Ces résistances d'isolement doivent éviter qu'un partie de l'équipement électronique, éventuellement défaillante, impose un niveau de tension, bas ou fixe, non convenable, tel que la masse, sur les liaisons. Elles doivent aussi permettre de relire les mémoires non volatiles même si la machine est hors tension, en cas de panne d'alimentation. Dans ces conditions l'outil de test injecte du courant dans les résistances en sorte que si ces résistances sont à des niveaux bas du côté de l'équipement électronique elles sont portées à niveau suffisant du côté des mémoires pour permettre leur bon fonctionnement.

La présente invention a pour but d'éviter les contraintes et les inconvénients liés à un tel couplage entre les mémoires non-volatiles et l'équipement électronique, d'une part, et un outil de test, d'autre part, en permettant l'obtention d'un couplage sélectif des mémoires avec l'équipement électronique ou avec l'outil de test.

La présente invention a donc pour objet un dispositif de couplage de mémoires non volatiles dans une machine électronique, permettant le couplage desdites mémoires à un équipement à microprocesseur de ladite machine et à un outil de test extérieur à premier connecteur terminal dit de test, comportant des liaisons connectées aux bornes d'accès desdites mémoires et à celles dudit équipement, pour leur couplage, et un deuxième connecteur complémentaire du connecteur de test relié aux liaisons, caractérisé en ce que ledit deuxième connecteur est monté directement en connecteur terminal sur les liaisons allant vers lesdites mémoires en les interrompant vers ledit équipement à microprocesseur et en ce qu'il comporte, en outre, un troisième connecteur, monté directement en connecteur terminal sur les liaisons allant vers ledit équipement à microprocesseur, et un circuit de raccordement monté amovible entre lesdits deuxième et troisième connecteurs, qui sélectivement assure le couplage direct des broches correspondantes des deuxième et troisième connecteurs pour assurer une continuité des liaisons entre les mémoires et l'équipement, quand il est interposé entre ces connecteurs, et permet le raccordement du connecteur de test sur ledit deuxième connecteur et l'isolation desdites mémoires entre elles et dudit équipement, quand il est retiré.

D'autres caractéristiques et les avantages de la présente invention apparaîtront au cours de la description donnée ci-après d'un mode de réalisation illustré dans les dessins annexés. Dans ces dessins :

- la figure 1 illustre le dispositif de couplage selon l'invention entre des mémoires non volatiles et un microprocesseur appartenant à l'équipement électronique d'une machine,
- la figure 2 illustre le dispositif de couplage selon l'invention, tel qu'il est utilisé pour le couplage des mémoires non volatiles précédentes à un outil de test,
- la figure 3 représente une machine à affranchir équipée dudit dispositif de couplage.

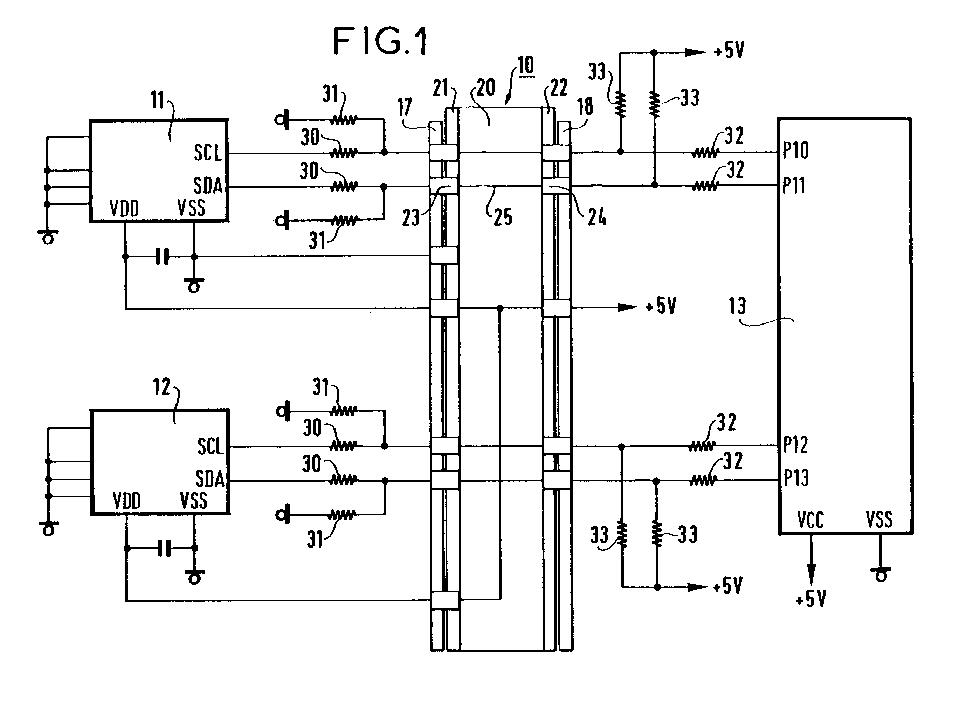

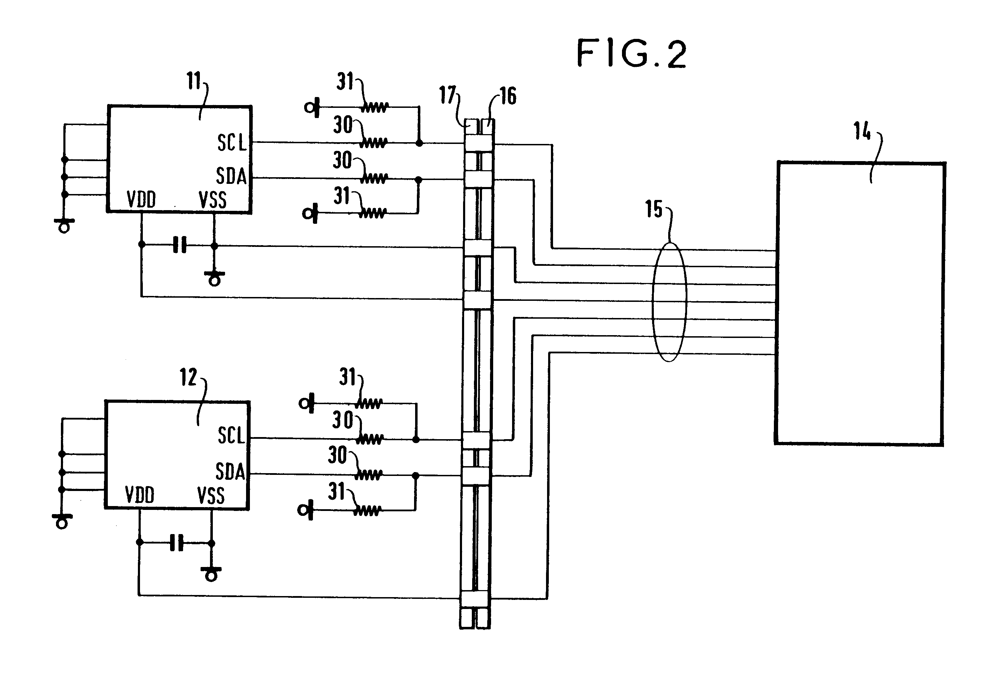

Dans les figures 1 et 2, on a représenté le dispositif de couplage 10 selon la présente invention tel qu'utilisé pour assurer le couplage sélectif entre deux mémoires non volatiles 11 et 12 et un microprocesseur 13 ou entre ces deux mémoires non volatiles et dispositif de test, dit outil de test 14. Cet outil de test 14 est à cordon de conducteurs 15 équipé d'un connecteur terminal 16, dit connecteur de test.

Dans les figures 1 et 2, on a montré les deux mémoires non volatiles 11 et 12 à accès série et noté leurs bornes d'accès actives VDD et VSS pour celles des alimentations +5V et OV, SCL pour celle d'horloge et SDA pour celle des données.

Ces mémoires sont des mémoires EEPROM (Electrically Erasable Programmable Read Only Memory, en terminologie anglo-saxonne) telles que celles du type X2404 de la société XICOR.

En variante, ces mémoires sont des mémoires RAM (Random Acces Memory) secourues par pile telles que celles au boîtier du type 8570 de la société RTC ou Signetics.

Dans la figure 1, les bornes d'accès actives SCL et SDA des deux mémoires 11 et 12 sont reliées, séparément pour chaque mémoire, aux bornes accès correspondantes notées P10, P11, P12, P13 du microprocesseur 13 et les bornes d'accès actives VDD et VSS à la source d'alimentation +5V et à la masse de l'ensemble de l'équipement électronique, auquel appartient le microprocesseur, par des liaison individuelles, non référencées. Ces liaisons individuelles ont été interrompues pour le montage du dispositif de couplage 10, selon l'invention, sur elles.

Ce dispositif de couplage 10 comporte un connecteur 17, complémentaire du connecteur de test 16, monté fixe, en connecteur terminal, sur les liaisons allant vers les mémoires, un connecteur 18 également monté fixe, en connecteur terminal sur les liaisons allant vers le microprocesseur et la source d'alimentation +5V et un circuit de raccordement 20 monté amovible entre les connecteurs fixes 17 et 18.

Pour l'une et l'autre des mémoires 11 et 12, chacune des bornes d'accès VDD, SDA et SCL est reliée à une des broches du connecteur fixe 17. La borne d'accès VDD de chaque mémoire l'est directement à sa broche du connecteur fixe 17, les bornes d'accès horloge SCL et données SDA le sont à travers une résistance série 30, de 330 ohms, pour chacun, à leur broche individuelle du connecteur fixe 17. De plus les liaisons horloge et données sont polarisées à la masse, chacune par une résistance 31, de 22 K ohms, connectée entre la broche à laquelle chacune de ces liaisons aboutit et la résistance 30 qu'elle comporte.

Dans la figure 1, les deux mémoires 11 et 12 et le microprocesseur 13 ont sur leur borne d'accès de masse VSS une masse commune pour tout l'équipement, ainsi que schématisé. Cette masse commune est également ramenée sur le dispositif de couplage 10, sur l'une des broches du connecteur fixe 17 du côté des mémoires par la liaison de cette broche à la borne d'accès VSS de l'une des mémoires, dans l'exemple illustre la mémoire 11.

Le connecteur fixe 17 a donc du côté des mémoires trois broches individuelles pour chacune des mémoires et une broche supplémentaire sur laquelle la liaison correspondante avec l'une des mémoires ramène la masse commune de l'ensemble. Pour les deux mémoires 11 et 12 il a donc au minimum sept broches.

Les bornes d'accès P10 à P13 du microprocesseur sont reliées, individuellement, à quatre broches correspondantes du connecteur fixe 18, chacune à travers une résistance série 32, de 300 ohms. Chacune de ces quatre liaisons incluant la résistance 32 est polarisée au +5V de l'alimentation par une résistance 33, de 8,2 K ohms. La source +5V est reliée directement à une autre broche du connecteur 18.

Le connecteur fixe 18, côté équipement électronique a au minimum cinq broches, une broche de masse commune n'étant pas nécessaire de ce côté, le dispositif 10 de couplage est déjà ramené à cette masse commune.

Ce circuit de raccordement 20 se présente sous la forme d'un boîtier plat rectangulaire ou d'un simple substrat, qui tel qu'illustré, a ses deux grands bords opposés équipés l'un et l'autre en connecteur, 21 et 22, selon le bord considéré. Le connecteur 21 est complémentaire du connecteur fixe 17. Il est, dans l'exemple illustré dans les figures 1 et 2, identique au connecteur de test 16. L'autre connecteur 22 est complémentaire du connecteur fixe 18. Dans le circuit de raccordement, les broches telles que 23 de l'un des deux connecteurs 21 et 22 sont reliées individuellement à celles correspondantes, telles que 24, de l'autre par des liaisons directes telles que 25 entre elles. Elles forment ainsi des couples de broches interconnectées qui établissent la continuité entre les liaisons allant vers les mémoires et celles allant vers le microprocesseur et la source d'alimentation +5V, lorsque le circuit de raccordement 20 est présent.

Dans le circuit de raccordement 20, les deux broches du connecteur 21, affectées à la continuité des liaisons de l'une et l'autre des mémoires 11 et 12 avec l'alimentation +5V, sont raccordées en commun directement à la broche correspondante du connecteur 22. Le connecteur 21 a ou n'a pas de broche correspondante à la broche de masse du connecteur fixe 17.

Si donc le circuit de raccordement 20, amovible, est enfiché sur les connecteurs fixes 17 et 18, le couplage des mémoires 11 et 12 avec le microprocesseur et la source d'alimentation +5V est assuré, tel que montré dans la figure 1 et les échanges entre le microprocesseur et les mémoires réalisés.

Avantageusement, les mémoires 11 et 12 de type série permettent ce couplage à travers peu de liaisons. Les échanges sont alors réalisés selon le protocole de communication défini par le fabricant des mémoires. Pour les mémoires à accès série considérées ne nécessitant que deux liaisons entre chacune d'elles et le microprocesseur, le protocole de communication est celui dit du bus I2C (inter Integrated Circuits), formé d'un bus bifilaire ayant une liaison de données et une liaison horloge.

Si par contre le circuit de raccordement 20 est déconnecté du connecteur fixe 17, on comprend à partir de la figure 1, que les mémoires 11 et 12 sont alors totalement isolées l'une de l'autre mais également de tout le reste de l'équipement électronique, en particulier du microprocesseur et de l'alimentation +5V. Elles restent cependant à la masse commune de l'équipement.

Dans la réalisation illustrée dans la figure 1 les résistances série 30 et 32 protègent les mémoires 11 et 12 et le microprocesseur 13 contre les chocs électriques possibles inhérents à la mise en place ou au retrait du circuit de raccordement 20.

Le retrait du circuit de raccordement 20 permet, ainsi que montré dans la figure 2, l'enfichage du connecteur terminal 16 de l'outil de test 14 sur le connecteur fixe 17, pour son raccordement direct avec les liaisons du côté des mémoires. Selon l'exemple illustré dans cette figure 2, le cordon de conducteurs 15 est à sept fils raccordé aux sept broches individuelles du connecteur de test 16. Dans ces conditions, chacune des mémoires est alimentée indépendamment l'une de l'autre à partir de l'outil de test, les liaisons entre l'outil de test et les bornes d'accès SCL et SDA des mémoires sont également séparées.

L'outil de test peut interroger les mémoires séparément, pour lire leur contenu.

On note que l'utilisation d'un cordon de cinq fils au lieu de sept est également possible, en prévoyant, entre ce cordon et le connecteur de test 16 restant à sept broches individuelles, un petit circuit imprimé supportant un boîtier de multiplexage commutant trois des fils venant de l'outil de test sur les liaisons allant vers les bornes d'accès VDD, SCL et SDA de l'une des mémoires ou l'autre. Le quatrième des cinq fils venant de l'outil de test est affecté à la broche de masse du connecteur fixe 17 et le cinquième à la sélection de commutation vers l'une ou l'autre des mémoires de l'outil de test.

En variante, dans le connecteur 17 les broches individuelles peuvent avoir une disposition différente de celle illustrée. En particulier la broche de masse peut être centrale et les autres broches, affectées aux liaisons avec les bornes d'accès VDD, VSS et SCL de l'une et l'autre des mémoires, peuvent être symétriques de la broche centrale. Dans ces conditions le connecteur de test peut n'être qu'à quatre broches reliées par un cordon de quatre fils à l'outil de test ; ce connecteur de test peut être raccordé alors à l'une ou l'autre des mémoires.

L'outil de test étant couplé à l'une ou l'autre des mémoires 11 et 12, le protocole utilisé par l'outil de test reste alors identique à celui utilisé pour les échanges entre le microprocesseur et les mémoires. C'est avantageusement celui du BUS I2C. La procédure de test permet d'utiliser un signal d'horloge de fréquence permettant une lecture lente des mémoires, restant compatible avec l'emploi d'un cordon 15 de plusieurs mètres de longueur. Les résistances série 30 sur les liaisons vers les mémoires servent à les protéger contre d'éventuelles surtensions induites dans le cordon.

L'insertion du connecteur 17, complémentaire de celui de test 16, directement sur les liaisons entre les mémoires à accès série et le microprocesseur (figure 1) rend particulièrement aisés les tests réalisés par l'outil de test sur les mémoires. En particulier, la suppression des longueurs de liaison en dérivation pour le connecteur de test, dans les couplages antérieurs connus, et l'adoption d'un nombre limité de conducteurs dans le cordon 15 de l'outil de test, découlant des mémoires à accès série et du peu de broches du connecteur 17, permettent l'utilisation d'un cordon souple et de longueur confortable.

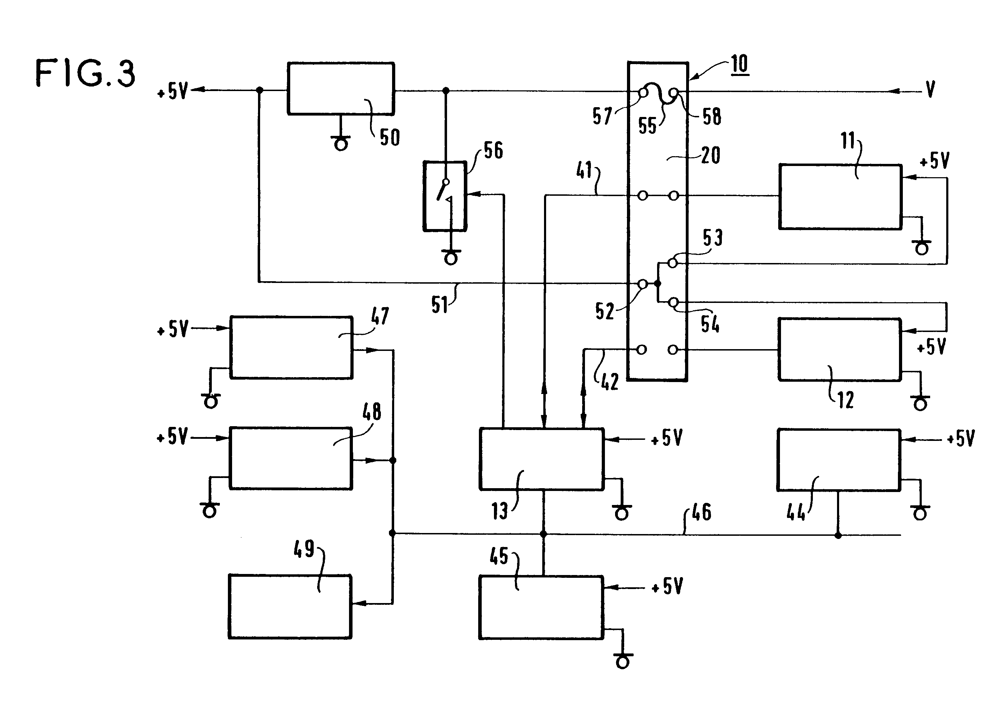

Dans la figure 3, on a représenté une machine à affranchir électronique. Les circuits comparables à ceux de la figure 1 sont désignés par les mêmes références.

Le microprocesseur 13 est celui autour duquel est organisé la machine. Les mémoires 11 et 12 précitées sont les mémoires non volatiles d'enregistrement de l'état des compteurs de la machine. Elles sont couplées au microprocesseur 13 à travers le dispositif 10 comme dans la figure 1, en constituant entre chaque mémoire et le microprocesseur un bus bifilaire indépendant, de transfert de données et d'horloge, pour l'enregistrement par voie distincte de l'état de la machine dans les mémoires. Dans la figure 3, le bus bifilaire est référencé 41 pour la mémoire 11 et 42 pour la mémoire 12.

Dans la figure 3, on voit que la machine comporte, en outre, une mémoire de travail 44 et une mémoire de commande 45 reliées au microprocesseur par un bus 46, un afficheur 47, un clavier 48 et une tête d'impression 49 également reliés au bus 46.

On a également illustré un circuit de régulation 50 délivrant à partir d'une source non régulée V l'alimentation régulée +5V à l'équipement électronique. Cette alimentation régulée +5V est délivrée aux mémoires à travers le dispositif de couplage, ainsi que montré par une liaison 51 avec le circuit 50 qui aboutit à une des broches 52 du circuit 10. A cette broche 52 correspondent deux broches 53, 54 qui lui sont directement raccordées et qui sont raccordées aux mémoires 11, 12. En l'absence du circuit de raccordement 20, les mémoires non volatiles sont isolées du circuit 50.

En outre, ainsi qu'il est connu, les machines à affranchir sont pourvues d'un organe basculant, en particulier un fusible 55 interposé entre la source non régulée et le circuit de régulation 50. Ce fusible est commandé à partir du microprocesseur à travers un circuit de commande 56. Il permet le blocage de la machine, par coupure de l'alimentation de tout l'équipement en cas d'anomalie détectée. Une telle anomalie est notamment une détection de non coïncidence entre les contenus des deux mémoires non volatiles 11 et 12 avant chaque affranchissement à réaliser. Ce fusible et tout l'équipement de la machine sont dans une enceinte de la machine, l'enceinte est plombée lors de la mise en service de la machine.

Selon l'invention, le fusible 55 est porté par le circuit de raccordement 20 précité où il est raccordé par une broche de raccordement supplémentaire 57 pour la liaison allant vers l'alimentation régulée 50 et une broche de raccordement supplémentaire 58 pour celle allant vers l'alimentation non régulée V. Ces broches supplémentaires 57 et 58 montrées sur le dispositif de couplage 10, qui interposent le fusible entre la source régulée 50 et celle non régulée V, correspondent aux dispositions de la figure 1 ; à chacune d'elles correspond, comme illustré dans la figure 1 pour les liaisons entre les mémoires et le microprocesseur, une broche du connecteur fixe 17, ou 18, et une paire de broches raccordées directement du circuit de raccordement.

En cas de panne de la machine, pour laquelle il y a intervention d'un représentant du service postal, la machine est déplombée et le circuit de raccordement 20 retiré, pour la procédure de test, le fusible monté par le circuit de raccordement peut être aisément vérifié et changé lors de la remise en état opérationnel de la machine. La machine est ensuite replombée.

En regard des figures 1 et 3, dans la machine où les mémoires non volatiles 11 et 12 sont ainsi couplées sélectivement au microprocesseur, le microprocesseur est apte à détecter la présence ou l'absence du circuit de raccordement 20 sur ses liaisons avec les mémoires. Les dispositions de détection de présence ou d'absence du circuit de raccordement 20 ne sont pas matérialisées dans les figures. Elles constituent de préférence, à chaque mise sous tension de la machine, tout au moins à la mise en service lorsque la machine est plombée, en une demande de lecture d'un octet connu contenu dans l'une ou l'autre des mémoires non volatiles.

La réponse ou non réponse à cette demande traduit la présence ou l'absence du circuit de raccordement 20. En cas d'absence du circuit de raccordement, le microprocesseur bloque la réalisation des affranchissements.

La présente invention a été décrite en regard des figures 1 à 3 jointes. Il est évident qu'en pratique, les connecteurs fixes 17, 18 pourront être montés en connecteur double porté par le bord du substrat sur lequel sont montés le microprocesseur et les mémoires non volatiles ou en connecteur double face imprimé sur un bord de ce substrat.

On lui associera avantageusement un détrompeur pour le montage convenable des connecteurs complémentaires portés par le circuit de raccordement ou du connecteur terminal de l'outil de test.

**Revendications**

1. Dispositif de couplage de mémoires (11, 12) non volatiles dans une machine électronique, permettant le couplage desdites mémoires à un équipement à microprocesseur de ladite machine et à un outil de test extérieur à premier connecteur terminal (16) dit de test, comportant des liaisons connectées aux bornes d'accès desdites mémoires et à celles dudit équipement, pour leur couplage, et un deuxième connecteur (17) complémentaire du connecteur de test (16) relié aux liaisons, caractérisé en ce que ledit deuxième connecteur (17) est monté directement en connecteur terminal sur les liaisons allant vers lesdites mémoires (11, 12) en les interrompant vers ledit équipement à microprocesseur et en ce qu'il comporte, en outre, un troisième connecteur (18), monté directement en connecteur terminal sur les liaisons allant vers ledit équipement à microprocesseur (13), et un circuit de raccordement (20) monté amovible entre lesdits deuxième et troisième connecteurs, qui sélectivement assure le couplage direct des broches correspondantes des deuxième et troisième connecteurs pour assurer une continuité des liaisons entre les mémoires et l'équipement, quand il est interposé entre ces connecteurs, et permet le raccordement du connecteur de test (16) sur ledit deuxième connecteur (17) et l'isolation desdites mémoires (11, 12) entre elles et dudit équipement, quand il est retiré.

2. Dispositif selon la revendication 1, caractérisé en ce que ledit circuit de raccordement (20) est un circuit plat équipé d'un quatrième connecteur (21) complémentaire du deuxième (17) et d'un cinquième connecteur (22) complémentaire du troisième (18) et ayant des interconnexions directes (25) entre les broches correspondantes (23, 24) desdits quatrième et cinquième connecteurs (21, 22).

3. Dispositif de couplage selon l'une des revendications 1 et 2, caractérisé en ce qu'il comporte des résistances série sur celles des liaisons allant vers les bornes d'accès de données (SDA) et d'horloge (SCL) de chacune des mémoires et sur celles allant vers les bornes d'accès correspondantes (P10 - P13) du microprocesseur (13).

4. Dispositif de couplage selon l'une des revendications 1 à 3, caractérisé en ce qu'il comporte, sur ledit deuxième connecteur (17), une broche sur laquelle est ramenée la masse commune de l'équipement, par une liaison avec la borne d'accès de masse (VSS) de l'une des mémoires (11, 12) assurant la mise à ladite masse commune du circuit de raccordement (20) quand il est interposé entre lesdits deuxième et troisième connecteurs (17, 18) et dudit outil de test (14) quand le connecteur de test (16) est raccordé au deuxième connecteur (17).

5. Machine à affranchir comportant un microprocesseur (13), deux mémoires non volatiles (11, 12) dites mémoires de l'état de la machine reliées indépendamment l'une de l'autre au microprocesseur, pour l'enregistrement de l'état des compteurs de la machine dans chacune d'elles, et une source d'alimentation non régulée V reliée à un circuit de régulation (50) alimentant l'ensemble des circuits de la machine, et faisant application dudit dispositif de couplage selon les revendications 1 à 4 pour le couplage des mémoires au microprocesseur, caractérisée en ce que lesdites mémoires (11, 12) sont à accès série et sont couplées, à travers ledit dispositif de couplage (10), au microprocesseur par un bus bifilaire indépendant pour chacune d'elles (41, 42) et à la source d'alimentation par une liaison double allant vers les deux mémoires et une liaison commune allant vers le circuit de régulation (50).

6. Machine à affranchir selon la revendication 5, caractérisée en ce que les échanges de données et d'horloge entre les mémoires (11, 12) et le microprocesseur (13) ou l'outil de test (14) se font selon un protocole de communication dit de bus I2C.

7. Machine à affranchir selon l'une des revendications 5 et 6, comportant, en outre, un organe de blocage interposé sur une liaison entre la source de tension non régulée (V) et ledit circuit de régulation (50), et un circuit de commande (56) dudit organe de blocage commandé par ledit microprocesseur, caractérisée en ce que ledit organe de blocage (55) est porté par ledit circuit de raccordement amovible (20) où il est raccordé à deux broches qui lui sont affectées et en ce que lesdits deuxième et troisième connecteurs (17, 18) ont chacun une broche affectée à l'interposition du fusible sur la liaison entre la source non régulée (V) et ledit circuit de régulation (50).

8. Machine à affranchir selon l'une des revendications 5, 6 et 7, caractérisée en ce que le microprocesseur (13) comporte des moyens de détection de présence ou d'absence dudit circuit de raccordement (20) sur ses liaisons avec lesdites mémoires (11, 12), pour bloquer la réalisation d'affranchissement en cas d'absence dudit circuit de raccordement.

## Claims

1. A circuit for coupling non-volatile memories (11, 12) in an electronic machine, the circuit allowing said memories to be coupled to a microprocessor equipment of said machine and also to be coupled to an external test tool having a first terminal connector (16) referred to as a test connector, the circuit comprising links connected to the access terminals of said memories and to the access terminals of said equipment in view of their mutual coupling, and a second connector (17) complementary to the test connector (16) which is connected to said links, characterized in that said second connector (17) is mounted directly as a terminal connector on said links leading to said memories (11, 12) and interrupts their connection to said microprocessor equipment, and in that it further includes a third connector (18) mounted directly as a terminal connector on said links leading to the microprocessor equipment (13), and a connection circuit (20) removably mounted between said second and third connectors, thereby selectably providing direct coupling between corresponding pins of the second and third connectors in order to ensure continuity in the links between the memories and the equipment when said connection circuit is interposed between said second and third connectors, and enabling the test connector (16) to be connected to said second connector (17) while isolating said memories (11, 12) from one another and from said equipment, when said connection circuit is removed therefrom.

2. A circuit according to claim 1, characterized in that said connection circuit (20) is a flat circuit fitted with a fourth connector (21) complementary to the second connector (17) and with a fifth connector (22) complementary to the third connector (18), and having direct interconnections (25) between corresponding pins (23, 24) of said fourth and fifth connectors (21, 22).

3. A coupling circuit according to claim 1 or 2, characterized in that it includes series resistances on those of the links which go to the data and the clock access terminals (SDA, SCL) of each of the memories and on those of the links going to the corresponding access terminals (P10 - P13) of the microprocessor (13).

4. A coupling circuit according to any one of claims 1 to 3, characterized in that it includes a pin on said second connector (17) which is connected to the common ground of the equipment via a link to the ground access terminal (VSS) of one of the memories (11, 12) thus ensuring that the connection circuit (20) is connected to said common ground when it is interposed between said second and third connectors (17, 18), and ensuring that said test tool (14) is connected to said common ground when the test connector (16) is connected to said second connector (17).

5. A franking machine comprising a microprocessor (13) having two non-volatile memories (11, 12) for storing the machine state, said memories being connected to said microprocessor independently from each other in order to record the states of the machine meters in each of them, said franking machine further including a non-regulated power supply V connected to a regulator circuit (50) for powering the circuits in the machine, said franking machine making use of said coupling circuit according to claims 1 to 4 for coupling the memories to the microprocessor, and being characterized in that said memories (11, 12) are serial access memories and are coupled via said coupling circuit (10) to the microprocessor via independent two-wire buses for each of them (41, 42) and to the power source via a pair of links going to each of the two memories and a common link going to said regulator circuit (50).

6. A franking machine according to claim 5, characterized in that the data and clock interchanges between the memories (11, 12) and the microprocessor (13) or the test tool (14) take place using a communications protocol known as the I2C bus protocol.

7. A franking machine according to claim 5 or 6, further including a locking member interposed on the link between the non-regulated voltage supply (V) and said regulator circuit (50), and a control circuit (56) for controlling said locking member and under the control of said microprocessor, characterized in that said locking member (55) is mounted on said removable connection circuit (20) where it is connected between two terminals attributed thereto, and in that said second and third connectors (17, 18) each has one terminal for interposing said locking member in the link between the non-regulated source (V) and said regulator circuit (50).

8. A franking machine according to claim 5, 6, or 7, characterized in that the microprocessor (13) includes means for detecting the presence or absence of said connection circuit (20) on its links with said memories (11, 12) in order to prevent franking from taking place in the absence of said connection circuit.

**Patentansprüche**

1. Kopplungseinrichtung für nichtflüchtige Speicher (11, 12) in einer elektronischen Maschine, die das Ankoppeln der Speicher an eine Mikroprozessoranlage der Maschine sowie an ein äußeres Prüfwerkzeug ermöglicht, das einen ersten Verbinder (16), Prüfstecker genannt, besitzt, mit Verbindungen, die an die Klemmen der Speicher und die der Anlage zur Kopplung desselben angeschlossen sind, und mit einem zweiten Verbinder (17) komplementär zum Prüfstecker (16), der an die Verbindungen angeschlossen ist, dadurch gekennzeichnet, daß der zweite Verbinder (17) direkt als Endverbinder an die zu den Speichern (11, 12) führenden Verbindungen angeschlossen ist, indem er diese in Richtung zur Mikroprozessoranlage unterbricht, und daß die Einrichtung weiter einen dritten Verbinder (18), der direkt als Endverbinder an die zur Mikroprozessoranlage (13) führenden Verbindungen angeschlossen ist, und eine Kopplungsschaltung (20) aufweist, die entfernbar zwischen dem zweiten und dritten Verbinder angebracht ist und selektiv die direkte Kopplung der entsprechenden Stifte des zweiten und dritten Verbinders bewirkt, um eine durchgängige Verbindung zwischen den Speichern und der Anlage zu gewährleisten, wenn sie zwischen diese Verbinder eingefügt ist, und die den Anschluß des Prüfsteckers (16) an den zweiten Verbinder (17) und die Trennung der Speicher (11, 12) voneinander und von der Anlage ermöglicht, wenn die Kopplungsschaltung herausgezogen ist.

2. Einrichtung nach Anspruch 1, dadurch gekennzeichnet, daß die Kopplungsschaltung (20) eine Flachschaltung ist, die mit einem vierten Verbinder (21) komplementär zum zweiten (17), sowie mit einem fünften Verbinder (22) komplementär zum dritten (18) ausgestattet ist und die direkte Zwischenverbindungen (25) zwischen den entsprechenden Stiften (23, 24) des vierten und fünften Verbinders (21, 22) aufweist.

3. Kopplungseinrichtung nach einem der Ansprüche 1 und 2, dadurch gekennzeichnet, daß sie Reihenwiderstände in denjenigen Verbindungen, die zu den Datenklemmen (SDA) und den Taktklemmen (SCL) jedes Speichers führen, sowie in denjenigen Verbindungen aufweist, die zu den entsprechenden Klemmen (P10-P13) des Mikroprozessors (13) führen.

4. Kopplungseinrichtung nach einem der Ansprüche 1 bis 3, dadurch gekennzeichnet, daß sie auf dem zweiten Verbinder (17) einen Stift aufweist, an den die gemeinsame Masse der Anlage über eine Verbindung mit der Massenklemme (VSS) eines der Speicher (11, 12) gelegt ist, wobei diese Klemme die Erdung der Kopplungsschaltung (20) an die gemeinsame Masse bewirkt, wenn die Schaltung zwischen den zweiten und dritten Verbinder (17, 18) eingefügt wird, und die Erdung des Prüfwerkzeugs (14), wenn der Prüfstecker (16) an den zweiten Verbinder (17) angeschlossen wird.

5. Frankiermaschine mit einem Mikroprozessor (13), zwei nichtflüchtigen Speichern (11, 12), Zustandsspeicher der Maschine genannt, die unabhängig voneinander an den Mikroprozessor zur Registrierung des Zählerstandes der Maschine in jedem Speicher angeschlossen sind, und mit einer nichtgeregelten Versorgungsquelle V, die an eine Regelungsschaltung (50) angeschlossen ist und die Gesamtheit der Schaltungen der Maschine speist, wobei die Maschine die Kopplungseinrichtung gemäß den Ansprüchen 1 bis 4 zum Ankoppeln der Speicher an den Mikroprozessor verwendet, dadurch gekennzeichnet, daß die Speicher (11, 12) Serienzugriffsspeicher sind und über die Kopplungseinrichtung (10) und je einen unabhängigen Zweidrahtbus (41, 42) an den Mikroprozessor, und über eine zu den beiden Speichern führende Doppelverbindung zur Versorgungsquelle sowie über eine gemeinsame Verbindung an die Regelungsschaltung (50) führen.

6. Frankiermaschine nach Anspruch 5, dadurch gekennzeichnet, daß der Daten- und Taktaustausch zwischen den Speichern (11, 12) und dem Mikroprozessor (13) oder dem Prüfwerkzeug (14) gemäß einem Kommunikationsprotokoll, genannt I2C-Busprotokoll, erfolgt.

7. Frankiermaschine nach einem der Ansprüche 5 und 6, mit weiter einem Blockierorgan, das in eine Verbindung zwischen der nichtgeregelten Spannungsquelle (V) und der Regelungsschaltung (50) eingefügt ist, und mit einer vom Mikroprozessor betätigten Steuerschaltung (56) für das Blockierorgan, dadurch gekennzeichnet, daß das Blockierorgan (55) von der entfernbaren Kopplungsschaltung (20) getragen wird, wo es an zwei ihm zugewiesene Stifte angeschlossen ist, und daß der zweite und dritte Verbinder (17, 18) jeweils einen Stift aufweisen, der der Einfügung der Sicherung in der Verbindung zwischen der nichtgeregelten Quelle (V) und der Regelungsschaltung (50) zugewiesen ist.

8. Frankiermaschine nach einem der Ansprüche 5, 6 und 7, dadurch gekennzeichnet, daß der Mikroprozessor (13) Einrichtungen zur Erfassung der An- oder Abwesenheit der Kopplungsschaltung (20) in den Verbindungen mit den Speichern (11, 12) aufweist, um die Freistempelungen bei nicht vorhandener Kopplungsschaltung zu sperren.

# FIG.1

EP 0 285 955 B1

FIG.2

**FIG.3**

EP 0 285 955 B1